Europäisches Patentamt

European Patent Office

Office européen des brevets

(11) Veröffentlichungsnummer: **0 436 753 B1**

(12) **EUROPÄISCHE PATENTSCHRIFT**

(45) Veröffentlichungstag der Patentschrift: **25.05.94**

(51) Int. Cl.5: **H01L 21/331**

(21) Anmeldenummer: **90100320.2**

(22) Anmeldetag: **08.01.90**

(54) **Verfahren zur Herstellung eines selbstjustierten Emitter-Basis-Komplexes.**

(43) Veröffentlichungstag der Anmeldung:
**17.07.91 Patentblatt 91/29**

(45) Bekanntmachung des Hinweises auf die Patenterteilung:
**25.05.94 Patentblatt 94/21**

(84) Benannte Vertragsstaaten:
**DE FR GB IT NL**

(56) Entgegenhaltungen:
**EP-A- 0 240 307**
**US-A- 4 868 633**

**IEEE ELECTRON DEVICE LETTERS, Band EDL-7, Nr. 1, Januar 1986, Seiten 8-10, IEEE, New York, US; M.F. CHANG et al.: "GaAs/(GaAl)As heterojunction bipolar transistors using a self-aligned substitutional emitter process"**

(73) Patentinhaber: **SIEMENS AKTIENGESELL-SCHAFT**
**Wittelsbacherplatz 2**
**D-80333 München(DE)**

(72) Erfinder: **Hoepfner, Achim, Dipl.-Ing.**
**Magdalenenstrasse 5**
**D-8033 Planegg(DE)**
Erfinder: **Tews, Helmut, Dr. Dipl.-Phys.**
**Carl-Orff-Weg 1**
**D-8025 Unterhaching(DE)**
Erfinder: **Zwincknagl, Peter, Dr. Dipl.-Phys.**
**Bruckenäcker 5**
**D-7000 Stuttgart 80(DE)**

## Beschreibung

Bei der Herstellung von Heterobipolartransistoren (HBT) im Materialsystem GaAs/AlGaAs werden in der Regel die Epitaxieschichten für den Kollektor, die Basis, den Emitter, den Kollektoranschluß und den Emitteranschluß ganzflächig abgeschieden. Erst danach werden diese Schichten strukturiert und durch die verschiedensten Prozesse (z. B. Implantationen, Rückätzschritte) verändert bzw. entfernt.

Die Funktion des HBT wird wesentlich beeinflußt durch die Ausgestaltung des selbstjustierten Emitter-Basis-Komplexes im Bereich der hochdotierten Emitter-Kontaktschichten. Diese Kontaktschichten bestehen üblicherweise aus einer $n^+$-GaAs-Schicht und einer gradierten $n^+$-$In_yGa_{1-y}$As-Schicht.

Wenn während der HBT-Herstellung die Kontaktschichten nicht vollständig entfernt bzw. isoliert werden, führt das zu einer unerwünschten parasitären Emitter-Basis-Seitenwanddiode, die die Stromverstärkung im HBT stark reduziert. Die optimalen Bedingungen sind bei den bekannten Herstellungsverfahren nur schwer herstellbar.

In der Regel bestehen die Emitter-Kontaktschichten aus 0,1 bis 0,2 $\mu$m dickem $n^+$-GaAs (Dotierungshöhe etwa $5 \times 10^{18}$ cm$^{-3}$) und einer darauf aufgewachsenen 0,03 bis 0,1 $\mu$m dicken gradierten $n^+$-$In_yGa_{1-y}$As-Schicht (y größer als 0,5; Dotierungshöhe größer als $10^{19}$ cm$^{-3}$). Im selbstjustierten Prozeß wird das hochtemperaturstabile Wolframsilizid verwendet. Ein solcher Herstellungsprozeß ist in der Veröffentlichung K. Ishii, T. Oshima, T. Fatatsugi, F. Fujii, N. Yokoyama, A. Shibatomi: "High-Temperature Stable $W_5Si_3/In_{0.53}Ga_{0.47}$As Ohmic Contacts to GaAs For Self-Aligned HBTs" in IEDM 86, 274-277 (1986) beschrieben. Entsprechend Fig. 8 dieser Veröffentlichung wird bei diesem Herstellungsprozeß zunächst auf $In_{0.53}Ga_{0.47}$As-Schichten, die auf für Heterobipolartransistoren übliche Epitaxieschichten aufgewachsen wurden, ein $W_5Si_3$-Film aufgebracht. Dieser Wolframsilizidfilm und darunterliegende Emitterkontaktschichten wurden in Form des Emitters geätzt und Berylliumionen für die Ausbildung der Basisbereiche implantiert. Das Wolframsilizid diente dabei als Implantierungsmaske. Nach dem Ausheilen der Implantate wurden die Basiselektroden mittels herkömmlicher Photolithographie hergestellt.

Bei vielen bekannten HBT-Prozeßvarianten wird z. B. das Wolframsilizid durch reaktives Ionenätzen ($CF_4$ bzw. $SF_6$) strukturiert und InGaAs- und $n^+$-GaAs-Kontaktschichten mit Trockenätzverfahren für diese Materialien geätzt. Auch naßchemische Ätzungen werden zum Rückätzen der Kontaktschichten verwendet. Ein derartiges Verfahren ist in der Veröffentlichung R.J. Malik, L.M. Lundardi, R.W. Ryan, S.C. Schunk, M.D. Feuer: "Submicron Scaling of AlGaAs/GaAs Self-Aligned Thin Emitter Hererojunction Bipolar Transistors (SATE-HBT) with Current Gain Independent of Emitter Area" in Electronics Letters 25, 1175 - 1177 (1989) beschrieben. Bei diesem Verfahren wird auf ein semiisolierendes Substrat aus GaAs eine Epitaxieschichtfolge bestehend aus einer n-dotierten GaAs-Schicht, einer n-dotierten AlGaAs-Schicht, einer n-dotierten GaAs-Schicht, einer niedriger n-dotierten GaAs-Schicht, einer p-dotierten AlGaAs-Schicht, einer n-dotierten AlGaAs-Schicht, einer n-dotierten GaAs-Schicht, einer n-dotierten GaInAs-Schicht aufgewachsen. Darauf wird ganzflächig eine Wolframschicht abgeschieden und auf dieser Wolframschicht wird mittels Abhebetechnik ein Emitter aus einer Ti/Au/Ni-Schichtfolge hergestellt und anschließend mittels reaktiven Ionenätzens die Wolframschicht auf die Abmessungen dieses Emitters rückgeätzt. In einem nachfolgenden Schritt wird naßchemisches Ätzen eingesetzt, um die Deckschicht aus GaInAs rückzuätzen, und danach wird die darunter befindliche GaAs-Schicht mittels reaktiven Ionenätzens selektiv rückgeätzt. Die Emitterschicht aus AlGaAs ist dann freigelegt und wird mittels Abhebetechnik mit AuBe-Kontakten versehen. Seitliches Rückätzen der Schichtfolge bis zu der n-dotierten AlGaAs-Schicht legt diese für die Kontaktierung des Kollektors frei. Dabei wird wieder naßchemisches Ätzen und selektives reaktives Ionenätzen eingesetzt. Bei diesen Verfahren ist die Elimination der Leckströme zwischen Emitter und Basis ein großes Problem, d. h. die optimale Eliminierung der Emitter-Basis-Seitenwanddiode.

In IEEE Electron Device Letters EDL-7, 8 bis 10 (1986) ist ein Herstellungsprozeß für einen Heterobipolartransistor mit selbstjustiertem Emitter beschrieben. Bei diesem Verfahren werden auf einer Schichtstruktur, wie sie für einen HBT üblich ist, eine Schicht aus Polymethylmetacrylat (PMMA) und eine Fotolackschicht übereinander abgeschieden. Diese Schichten werden so strukturiert, daß der für die Basis vorgesehene Bereich frei bleibt und die Fotolackschicht als Maske überhängende Kanten bildet. In dem Bereich der Öffnung werden die Deckschicht und die Emitterschicht weggeätzt. Dann erfolgt unter Verwendung dieser Maske aus Fotolack als Dummy-Emitter eine Implantation für den Leitfähigkeitstyp der Basis. Anschließend wird der Fotolack entfernt und ganzflächig eine Schicht aus SiO aufgebracht, von der Anteile in Abhebetechnik mit der PMMA-Schicht entfernt werden. Das verbleibende SiO befindet sich auf dem Basisbereich und den angrenzenden Rändern. Es wird ganzflächig ein $Si_3N_4$-Film als Schutzschicht aufgebracht und die Implantation ausgeheilt. Nach dem Entfernen des $S_3^jN_4$ werden die Kontakte für Basis und Emitter aufgebracht.

In der US 4 868 633 ist ein Verfahren für selektive Epitaxie von GaAs beschrieben. Bei diesem Verfahren wird durch eine Maske aus $W_5Si_3$, das mit Zink dotiert ist, das Aufwachsen von GaAs verhindert. Mittels dieses Verfahrens kann ein HBT hergestellt werden, indem ein Emitter-Basis-Komplex in der Öffnung einer solchen $W_5Si_3$-Maske selektiv gewachsen wird.

Aufgabe der vorliegenden Erfindung ist es, ein Herstellungsverfahren für einen selbstjustierten Emitter-Basis-Komplex anzugeben, das einerseits einfach auszuführen ist und andererseits die mit dem Rückätzen von Epitaxieschichten verbundenen Probleme vermeidet.

Diese Aufgabe wird mit dem Verfahren mit den Verfahrensschritten nach Anspruch 1 gelöst. Weitere Ausgestaltungen ergeben sich mit den zusätzlichen Merkmalen der Unteransprüche.

Es folgt eine Beschreibung des erfindungsgemäßen Herstellungsverfahrens anhand der Fig. 1 bis 12.

Die Fig. 1 bis 7 zeigen im Querschnitt den jeweiligen Aufbau des Emitter-Basis-Komplexes nach verschiedenen Schritten des Herstellungsverfahrens in einer bestimmten Ausführungsform.

Die Fig. 8 bis 10 zeigen im Querschnitt die den Fig. 1, 6 und 7 entsprechenden Verfahrensschritte bei einem alternativen Ausführungsbeispiel.

Die Fig. 11 und 12 zeigen den Fig. 1 und 6 entsprechende Querschnitte bei einem dritten Ausführungsbeispiel.

Bei dem erfindungsgemäßen Verfahren wird die Schichtenfolge für den Heterobipolartransistor in einem ersten Epitaxieschritt nur bis zu der Schicht gewachsen, die der optimalen Emitter-Basis-Schichtfolge im rückgeätzten bzw. isolationsimplantierten Teil des Heterobipolartransistors entspricht. Das Basisgebiet wird selbstjustiert zum Emittergebiet vorbereitet und die Emitterkontaktschichten erst nachher selbstjustiert zum Basisgebiet in einem zweiten Epitaxieschritt selektiv aufgewachsen und kontaktiert.

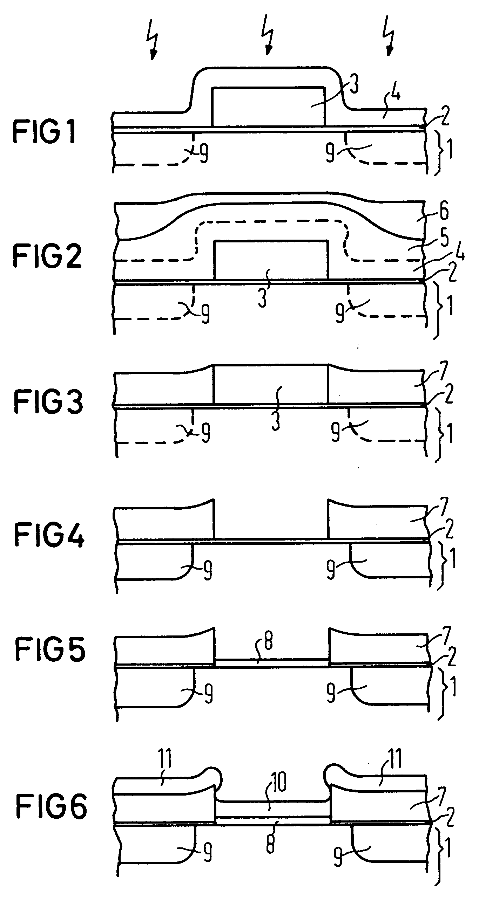

In einem ersten Epitaxieschritt werden die für einen Heterobipolartransistor üblichen Schichten (Subkollektorschicht, Kollektorschicht, Basisschicht, Emitterschicht aus z. B. AlGaAs und eine dünne niedrig n-dotierte GaAs-Schicht im GaAs-Materialsystem) auf ein Substrat aufgewachsen. Auf diese Epitaxieschichten 1 wird eine dünne Sputterschicht 2 (z. B. 100 nm SiN) abgeschieden. Darauf wird mittels Phototechnik ein Dummy-Emitter 3 hergestellt (s. Fig. 1). Als Spacer für eine nachfolgende $p^+$-Implantation wird eine 0,3 bis 0,5 $\mu$m dicke erste Dielektrikumschicht 4 (z. B. SiN) ganzflächig abgeschieden (z. B. mittels CVD). Dann wird die $p^+$-Implantation für den späteren Basiskontaktanschluß durchgeführt, wie durch die Pfeile in Fig. 1 angedeutet ist.

Anschließend wird eine zweite Dielektrikumschicht 5 (z. B. SiN) abgeschieden (z. B. mittels CVD), so daß die Gesamtdicke des Dielektrikums in etwa der des Dummy-Emitters 3 entspricht. Eine Photolackschicht 6 (z. B. AZ 111) zum Einebenen der Oberfläche wird dann ganzflächig aufgebracht. Die Folge dieser aufgebrachten Schichten und die Basisimplantation 9 sind in Fig. 2 dargestellt.

Die Photolackschicht 6, die erste und die zweite Dielektrikumschicht 4, 5 werden dann so weit rückgeätzt, daß die ursprüngliche Photolackstruktur, nämlich der Dummy-Emitter 3 wieder freiliegt. Dabei bleibt in dem von dem Dummy-Emitter 3 nicht bedeckten Bereich der Sputter-Schicht 2 von der ersten und gegebenenfalls der zweiten Dielektrikumschicht 4, 5 ein Anteil als Dielektrikummaske 7 stehen. Der Dummy-Emitter 3 dazwischen wird durch ein Lösungsmittel oder in einem Trockenätzschritt (z. B. $O_2$-Plasma) entfernt (vergl. Fig. 3 und 4).

Daraufhin erfolgt das Ausheilen der $p^+$-Implantation. Anschließend wird die dünne Sputterschicht 2 im Bereich des Emitters, d. h. in dem von der Dielektrikummaske 7 nicht bedeckten Bereich, naß- oder trockenchemisch entfernt. Auf der nun freiliegenden Oberfläche der Epitaxieschichten 1 (die Oberfläche der niedrig n-dotierten GaAs-Schicht) werden die Emitterkontaktschichten 8 aufgebracht. Diese Emitterkontaktschichten 8 können z. B. im GaAs-Materialsystem eine 0,1 bis 0,2 $\mu$m dicke, hoch n-dotierte GaAs-Kontaktschicht und eine im Anteil des Indiums gradierte $In_yGa_{1-y}As$-Kontaktschicht einer Dicke von 0,03 bis 0,1 $\mu$m sein. Auf der Dielektrikummaske 7 wächst dabei keine Epitaxieschicht auf (s. Fig. 5).

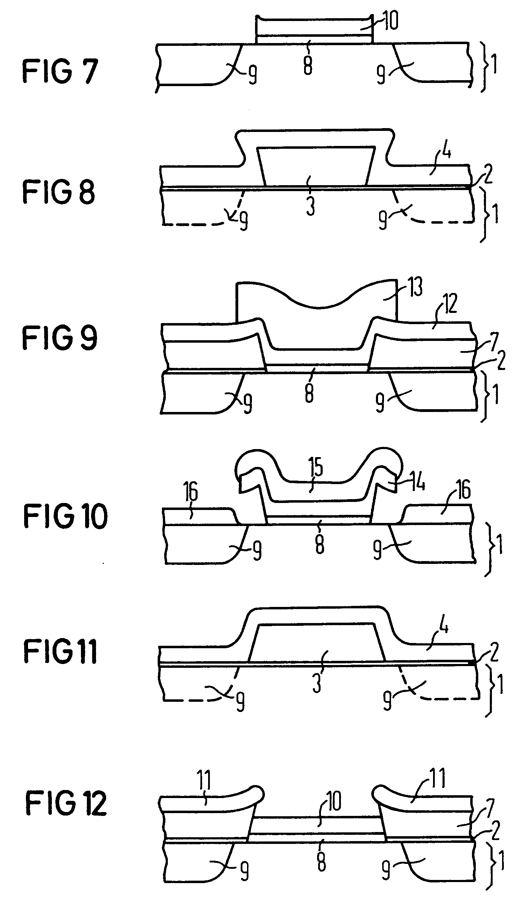

Dann wird ganzflächig eine Metallschicht für die Emittermetallisierung abgeschieden, die z. B. $WSi_x$ sein kann, wenn weitere Hochtemperaturschritte in dem Prozeß vorgesehen sind, oder ein anderer Kontakt für n-Halbleitermaterial wie z. B. Ge/Au/Cr/Au oder Ge/Au/Ni/Au. In Fig. 6 ist diese Metallschicht 11 mit einem Anteil als Emittermetallisierung 10 dargestellt. Die Dielektrikummaske 7 zusammen mit dem darauf befindlichen Anteil der Metallschicht 11 wird in Abhebetechnik entfernt. Übrig bleibt der Aufbau nach Fig. 7, bei dem die Emitterschichten 8 und die Emittermetallisierung 10 selbstjustiert zur Basisimplantation 9 ausgebildet sind. Die Abstände zwischen den Emitterkontaktschichten 8 und der Basisimplantation 9 sind über die Dicke der ersten Dielektrikumschicht 4 in dem in Fig. 1 dargestellten Prozeßschritt in gewissen Grenzen einstellbar.

Fig. 8 zeigt eine Ausführungsform, bei dem der Dummy-Emitter 3 mit überhängenden Kanten ausgebildet wird. Daraus ergibt sich, daß die Dielektrikummaske 7 entsprechend Fig. 9 schräge Flanken aufweist, so daß die Emittermetallisierung als zusammenhängende Metallschicht 12 aufgedampft wird. Diese Metallschicht 12 wird erst in einem weiteren Prozeßschritt mittels Phototechnik strukturiert. Das kann z. B. wie in Fig. 9 mit einer Lackmaske 13, die den Bereich der Emittermetallisierung abdeckt, geschehen. Der von dieser Lackmaske 13 nicht bedeckte Anteil der Metallschicht 12 wird weggeätzt. Danach kann die Dielektrikummaske 7 entfernt werden und die Emittermetallisierung 14 als Maske beim Aufdampfen einer weiteren Metallschicht 15 für die Basismetallisierung 16 verwendet werden. Auf diese Weise erhält man eine zur Emittermetallisierung 14 selbstjustierte Basismetallisierung 16. Gleichzeitig ist das implantierte Basisgebiet (Basisimplantation 9) selbstjustiert zum Emitter.

Eine weitere Ausführungsform zeigen die Fig. 11 und 12, bei denen der Dummy-Emitter 3 mit schrägen Flanken ausgebildet ist, was größere Sicherheit bei dem Abhebeschritt bietet und es gestattet, den Abstand zwischen Emitter- und Basisanschlußgebiet gegenüber den vorgenannten Ausführungsformen weiter zu verringern. Der in Fig. 11 im Querschnitt dargestellte Aufbau entspricht Fig. 1; Fig. 12 entspricht Fig. 6. Außerdem ist es möglich, den Dummy-Emitter statt aus Photolack aus Metall herzustellen (z. B. Aluminium). Dann wird bei dem Prozeßschritt entsprechend Fig. 4 der Dummy-Emitter nicht durch ein Lösungsmittel, sondern durch einen naßchemische Ätzschritt (z. B. Salzsäure) entfernt.

**Patentansprüche**

1. Verfahren zur Herstellung eines Heterobipolartransistors mit selbstjustiertem Emitter-Basis-Komplex, bei dem auf ein Substrat eine Folge von Epitaxieschichten (1) mit mindestens einer Kollektorschicht, einer Basisschicht und einer Emitterschicht aufgewachsen wird, dann mittels eines darauf aufgebrachten Dummy-Emitters (3) als Maske eine Basiskontaktimplantation (9) eingebracht wird, wobei das Rückätzen der Epitaxieschichten vermieden wird, dann eine den von dem Dummy-Emitter (3) nicht bedeckten Bereich abdeckende Dielektrikummaske (7) hergestellt wird, dann nach Entfernen des Dummy-Emitters (3) und Ausheilen der Basiskontaktimplantation (9) Emitterkontaktschichten (8) und Emittermetallisierungen (10) unter Verwendung dieser Dielektrikummaske (7) aufgebracht werden und schließlich nach Entfernen der Dielektrikummaske (7) die Basismetallisierung aufgebracht wird.

2. Verfahren nach Anspruch 1, bei dem auf die Epitaxieschichten (1) eine Sputterschicht (2) ganzflächig, darauf der Dummy-Emitter (3) aus Photolack und darauf eine erste Dielektrikumschicht (4) ganzflächig aufgebracht werden, danach die Basisimplantation (9) eingebracht wird, danach eine zweite Dielektrikumschicht (5) ganzflächig mindestens bis auf die Höhe des Dummy-Emitters (3) und darauf eine einebnende Photolackschicht (6) aufgebracht werden, danach die erste Dielektrikumschicht (4), die zweite Dielektrikumschicht (5) und die Photolackschicht (6) so weit abgeätzt werden, daß die Oberfläche des Dummy-Emitters (3) freigelegt ist und von der ersten und von der zweiten Dielektrikumschicht (4, 5) in dem von dem Dummy-Emitter (3) nicht bedeckten Bereich ein Anteil als Dielektrikummaske (7) stehenbleibt, danach der Dummy-Emitter (3) und der darunter befindliche Anteil der Sputterschicht (2) entfernt werden, die Emitterkontaktschichten (8) aufgewachsen werden und eine Metallschicht (11) ganzflächig aufgebracht wird und danach die Dielektrikummaske (7) mit dem darauf befindlichen Anteil dieser Metallschicht (11) entfernt wird, so daß von dieser Metallschicht (11) ein Anteil auf den Emitterkontaktschichten (8) als Emittermetallisierung (10) übrig bleibt.

3. Verfahren nach Anspruch 2, bei dem der Dummy-Emitter (3) mit überhängenden Kanten hergestellt wird.

4. Verfahren nach Anspruch 2, bei dem der Dummy-Emitter (3) mit schrägen Flanken hergestellt wird und vor dem Abheben der Dielektrikummaske (7) darauf befindliche Anteile der Metallschicht (12) mittels Maskentechnik entfernt werden.

5. Verfahren nach einem der Ansprüche 1 bis 4, bei dem als Emitterkontaktschichten (8) eine erste Kontaktschicht aus binärem Halbleitermaterial und darauf eine zweite Kontaktschicht aus ternärem Halbleitermaterial mit einer Gradierung in dem Anteil der dritten Materialkomponente aufgewachsen werden.

**Claims**

1. Method of fabricating a heterobipolar transistor having self-aligned emitter-base complex, in which a sequence of epitaxial layers (1) comprising at least one collector layer, one base layer and one emitter layer is grown on a substrate, then a base-contact implantation (9) is introduced by means of a dummy emitter (3), deposited thereon, as a mask, the back-etching of the epitaxial layers being avoided, then a dielectric mask (7) which covers the region not covered by the dummy emitter (3) is fabricated, then emitter contact layers (8) and emitter metallizations (10) are deposited using said dielectric mask (7) after removing the dummy emitter (3) and annealing the base-contact implantation (9), and, finally, the base metallization is deposited after removing the dielectric mask (7).

2. Method according to Claim 1, in which a sputtered layer (2) is deposited over the entire surface on the epitaxial layers (1), the dummy emitter (3) made of photoresist is deposited thereon and a first dielectric layer (4) is deposited over the entire surface on the latter, then the base implantation (9) is introduced, then a second dielectric layer (5) is deposited over the entire surface at least up to the height of the dummy emitter (3) and a levelling photoresist layer (6) is deposited thereon, then the first dielectric layer (4), the second dielectric layer (5) and the photoresist layer (6) are etched off until the surface of the dummy emitter (3) is exposed and, of the first and of the second dielectric layers (4, 5) in the region not covered by the dummy emitter (3), a portion is left as dielectric mask (7), then the dummy emitter (3) and the portion of the sputtered layer (2) situated thereunder are removed, the emitter-contact layers (8) are grown on and a metal layer (11) is deposited over the entire surface, and then the dielectric mask (7) with the portion of said metal layer (11) situated thereon is removed, so that, of said metal layer (11), a portion is left behind on the emitter-contact layers (8) as emitter metallization (10).

3. Method according to Claim 2, in which the dummy emitter (3) is fabricated with overhanging edges.

4. Method according to Claim 2, in which the dummy emitter (3) is fabricated with sloping sides and, before the dielectric mask (7) is lifted off, portions of the metal layer (12) situated thereon are removed by means of mask technology.

5. Method according to one of Claims 1 to 4, in which a first contact layer made of binary semiconductor material and, on top thereof, a second contact layer made of ternary semiconductor material with a gradation in the portion of the third material component are grown on as emitter-contact layers (8).

## Revendications

1. Procédé de fabrication d'un transistor hétérobipolaire comportant un complexe émetteur-base auto-aligné, selon lequel on fait croître, sur un substrat, une succession de couches épitaxiales (1) comprenant au moins une couche de collecteur, une couche de base et une couche d'émetteur,

   ensuite, en utilisant un faux émetteur (3) déposé sur la succession de couches, en tant que masque, on effectue une implantation (9) d'un contact de base, de manière à empêcher toute rétrogravure des couches épitaxiales,

   puis on forme un masque diélectrique (7), qui recouvre la zone non recouverte par le faux émetteur (3),

   puis, après élimination du faux émetteur (3) et réparation de l'implantation (9) de contact de base, on dépose des couches (8) de contact d'émetteur et des métallisations (10) d'émetteur en utilisant ce masque diélectrique (7), et enfin, après élimination du masque diélectrique (7), on dépose la métallisation de base.

2. Procédé suivant la revendication 1, selon lequel on dépose sur toute la surface des couches épitaxiales (1) une couche (2) formée par pulvérisation cathodique, sur la surface de laquelle on dépose le faux émetteur (3) en un vernis photosensible et sur toute la surface de celui-ci on dépose une première couche diélectrique (4),

   on met ensuite l'implantation de base (9),

   on dépose ensuite, sur toute la surface, une seconde couche diélectrique (5) au moins jusqu'à la hauteur de la couche du faux émetteur (3) et on dépose, sur cette couche, une couche de vernis photosensible (6) d'aplanissement,

   on élimine ensuite par gravure la première couche diélectrique (4), la seconde couche diélectrique (5) et la couche de vernis photosensible (6) au point de mettre à nu la surface du faux émetteur (3) et qu'une partie des première et seconde couches diélectriques (4, 5) subsiste, dans la zone non recouverte par le faux émetteur (3), en tant que masque diélectrique (7),

   on élimine ensuite le faux émetteur (3) et la partie, se trouvant sous cet émetteur, de la couche (2) déposée par pulvérisation cathodique, on fait croître les couches de contact d'émetteur (8) et on dépose sur toute la surface de ces couches une couche métallique (11), et

on retire ensuite le masque diélectrique (7) ainsi que la partie, se trouvant sur ce masque, de la couche métallique (11) de sorte qu'une partie de cette couche métallique (11) subsiste sur les couches de contact d'émetteur (8), en tant que métallisation d'émetteur (10).

3. Procédé suivant la revendication 2, selon lequel on fabrique le faux émetteur (3) avec des bords en surplomb.

4. Procédé suivant la revendication 2, selon lequel on fabrique le faux émetteur (3) avec des flancs obliques et, avant l'enlèvement du masque diélectrique (7), on élimine des parties de la couche métallique (12), se trouvant sur ce masque, au moyen d'une technique de masque.

5. Procédé suivant l'une des revendications 1 à 4, selon lequel on fait croître une première couche de contact en un matériau semiconducteur binaire et, sur cette dernière, une seconde couche de contact en un matériau semiconducteur ternaire avec une gradation de la proportion du troisième constituant.

FIG 1

FIG 2

FIG 3

FIG 4

FIG 5

FIG 6

FIG 7

FIG 8

FIG 9

FIG 10

FIG 11

FIG 12